Europäisches Patentamt

European Patent Office

Office européen des brevets

(19)

(11) **EP 1 333 587 A1**

(12) # DEMANDE DE BREVET EUROPEEN

(43) Date de publication:
06.08.2003 Bulletin 2003/32

(51) Int Cl.⁷: $H03M\ 13/41$

(21) Numéro de dépôt: 03354009.7

(22) Date de dépôt: 04.02.2003

(84) Etats contractants désignés:
**AT BE BG CH CY CZ DE DK EE ES FI FR GB GR HU IE IT LI LU MC NL PT SE SI SK TR**
Etats d'extension désignés:
**AL LT LV MK RO**

(30) Priorité: **04.02.2002 FR 0201306**

(71) Demandeur: **STMicroelectronics S.A.**
**92120 Montrouge (FR)**

(72) Inventeurs:
• **Urard, Pascal**
**38570 Theys (FR)**
• **Valentin, Thierry**
**38660 Le Touvet (FR)**

(74) Mandataire: **de Beaumont, Michel**
**Cabinet Michel de Beaumont**
**1, rue Champollion**
**38000 Grenoble (FR)**

(54) **Module ACS dans un décodeur**

(57) L'invention concerne un dispositif (10) pour réaliser une fonction de type addition-comparaison-sélection dans un décodeur de codes de correction d'erreur, comprenant des premiers et deuxièmes additionneurs (12, 14, 16, 18) pour additionner, respectivement pour des première et deuxième branches, des valeurs de métrique de branche ($GI_1$, $GI_2$), des valeurs intermédiaires de métrique d'état précédent ($MI_1$, $NI_2$), et des valeurs d'ajustement de métrique d'état précédent ($SI_1$, $SI_2$), formant ainsi des première et deuxième valeurs de métrique d'état actuel ; un comparateur (20), couplé aux premier (12, 14) et second (16, 18) additionneurs, pour sélectionner la valeur la plus élevée (MO) des première et deuxième valeurs ; des moyens (22, 24, 26, 27, 28) pour déterminer une valeur numérique d'ajustement de métrique d'état actuel (SO) comportant un seul bit, à partir des première et deuxième valeurs.

Fig 2

EP 1 333 587 A1

## Description

La présente invention concerne de façon générale les décodeurs de signaux, comme par exemple les décodeurs du type turbodécodeurs. Plus particulièrement, la présente invention concerne des modules particuliers utilisés dans de tels décodeurs, appelés généralement modules ACS ("Add-Compare-Select"-"Additionner-Comparer-Sélectionner") qui réalisent des opérations d'addition pour fournir deux données, puis de comparaison des deux données et de sélection d'une donnée parmi les deux données.

L'un des objectifs des communications numériques est la transmission de données sans erreur. Durant la transmission, les données sont soumises à du bruit qui peut causer des erreurs sur les données reçues. Pour améliorer la fiabilité lors de la transmission des données, on utilise des techniques de correction d'erreur. Une technique connue de correction d'erreur est le codage par convolution. Cette technique fournit une correction d'erreur efficace mais nécessite des techniques de décodage sophistiquées.

Les codes de correction d'erreur présentent un effet technique important puisqu'ils permettent la correction d'erreur de données transmises entre un émetteur et un récepteur dans des applications telles que les télécommunications.

Les codes de convolution permettent au récepteur de données numériques de déterminer correctement les données transmises même lorsque des erreurs se sont produites durant la transmission. Les codes de convolution introduisent des redondances dans les données à transmettre et fournissent les données transmises séquentiellement dans des paquets dans lesquels la valeur de chaque bit est dépendante de bits précédents dans la séquence. Ainsi, lorsque des erreurs se produisent, le récepteur peut déduire les données d'origine en retraçant les séquences possibles de données reçues.

Pour améliorer davantage l'efficacité du codage, des procédés de codage comprennent des brasseurs, qui mélangent l'ordre des bits du paquet codé. Ainsi, lorsque des bits adjacents sont altérés durant la transmission, l'erreur est répartie sur la totalité du paquet initial et peut être ainsi plus efficacement corrigée.

D'autres améliorations peuvent comprendre des codeurs qui codent les données à transmettre plus d'une fois, en parallèle ou en série. Par exemple, on connaît des procédés de correction d'erreur qui transmettent des paquets de données codées pour lesquels chaque paquet est formé par la juxtaposition de données initiales non codées, de premières données codées issues du codage des données initiales par un premier codeur, et de deuxièmes données codées issues du codage des données initiales par un second codeur précédé d'un brasseur. Un tel procédé de correction d'erreur est appelé codage convolutif parallèle systématique (CCPS).

De tels codes sont souvent décodés avec un algorithme itératif, appelé turbodécodage, relativement efficace pour atteindre des taux d'erreur relativement bas.

Pour de tels codes, un décodage optimal est souvent une tâche très complexe. On a ainsi développé des techniques de décodage itératives pour résoudre ce problème. Plutôt que de déterminer immédiatement si les données reçues sont égales à "0" ou à "1", le récepteur attribue à chaque donnée reçue une valeur sur une échelle à plusieurs niveaux représentant la probabilité que la donnée soit égale à "1". Une échelle classique, que l'on appelle de façon habituelle rapport de probabilité log ("log-likelihood ratio") LLR, représente chaque donnée décodée x par un entier dans une certaine échelle, par exemple de 1 à 15. Pour une donnée reçue r, le rapport LLR est déterminé de la façon suivante :

$$\text{LLR(x)} = \log\left(\frac{\Pr(\text{x} = 1/\text{r})}{\Pr(\text{x} = 0/\text{r})}\right) \qquad (1)$$

où $\Pr(\text{x}=1/\text{r})$ représente la probabilité que la donnée décodée x soit égale à "1" pour la donnée r reçue et $\Pr(\text{x}=0/\text{r})$ représente la probabilité que la donnée décodée x soit égale à "0" pour la donnée r reçue.

Le procédé de décodage itératif reçoit une séquence d'entrée correspondant à des probabilités pour chaque valeur reçue et fournit en sortie des probabilités corrigées. Le décodage itératif est réalisé par plusieurs itérations jusqu'à ce que l'on croie que la probabilité corrigée représente la donnée transmise de façon suffisamment proche.

On compare alors la valeur du rapport LLR à un seuil pour déterminer la valeur de la donnée décodée x. Par exemple, la donnée décodée est prise égale à "1" lorsque le rapport LLR est positif, et à "0" autrement. Le rapport LLR contient donc à la fois une information représentative de la valeur de la donnée décodée x et une information représentative de la fiabilité de la valeur de la donnée décodée.

L'algorithme de calcul du rapport LLR est basé sur un treillis similaire à celui utilisé dans l'algorithme de Viterbi.

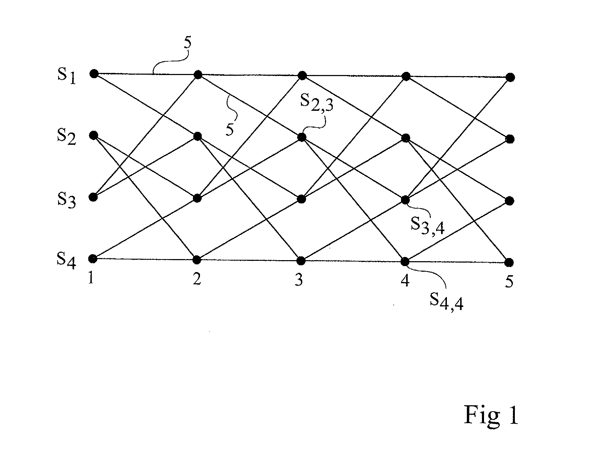

La figure 1 représente un exemple de treillis à N états, N étant égal à 4 en figure 1. Quatre états $S_i$, i allant de 1 à 4, sont représentés selon la direction verticale. Différents instants k, k allant de 1 à 5, sont représentés selon la direction horizontale. Chaque point $S_{i,k}$ du treillis représente le $i^{ème}$ état à l'instant k. Un état peut représenter une séquence d'un nombre déterminé de bits correspondant aux derniers bits reçus par le décodeur. Pour un treillis à quatre états, chaque état peut être associé à l'une des séquences ("00", "01", "10", "11"). Une branche 5 représente une transition entre un état à un instant k et un état à un instant k+1. La transition d'un état vers un autre correspond à la réception par le décodeur d'une donnée correspondant idéalement à un bit de valeur "0" ou "1". A partir d'un état à un instant k, par exemple l'état $S_{2,3}$, il n'y a donc que deux transitions possibles vers les états $S_{3,4}$ et $S_{4,4}$ selon que la donnée reçue est un bit de valeur "0" ou "1".

En pratique, la donnée $r_k$ reçue à un instant k est une donnée analogique. On détermine pour une branche du treillis reliant l'état $S_{i,k}$ et l'état $S_{m,k+1}$ une métrique $\gamma_k$ de la branche correspondant à une transition possible de l'état $S_{i,k}$ vers l'état $S_{m,k+1}$. La métrique de branche correspond à une distance entre la donnée reçue $r_k$ et la donnée $x_k(S_{i,k}, S_{m,k+1})$ qu'on aurait du recevoir pour la branche. Elle peut être calculée de la façon suivante :

$$\gamma_k(S_{i,k}, S_{m,k+1}) = e^{\dfrac{-1}{2\sigma^2}\left\|r_k - x_k(S_{i,k}, S_{m,k+1})\right\|^2} \qquad (2)$$

où $\sigma^2$ est la variance de bruit associée à la donnée reçue $r_k$.

L'algorithme de calcul du rapport LLR comporte trois étapes principales.

A un instant k, on calcule pour chaque état $S_{i,k}$, i allant de 1 à N, une probabilité amont $\alpha_k(S_{i,k})$ de se trouver à l'état $S_{i,k}$ de la façon suivante :

$$\alpha_k(S_{i,k}) = \sum_{\ell=1}^{N} \sum_{j=0}^{1} \alpha_{k-1}(S_{\ell,k-1}) \gamma_k^j(S_{\ell,k-1}, S_{i,k}) \qquad (3)$$

On calcule également à l'instant k, pour chaque état $S_{i,k}$, i allant de 1 à N, une probabilité aval $\beta_k(S_{i,k})$ de se trouver à l'état $S_{i,k}$ par l'équation suivante :

$$\beta_k(S_{i,k}) = \sum_{\ell=1}^{N} \sum_{j=0}^{1} \beta_{k+1}(S_{\ell,k+1}) \gamma_{k+1}^j(S_{i,k}, S_{\ell,k+1}) \qquad (4)$$

A partir de ces deux probabilités, on calcule le rapport LLR de la façon suivante :

$$LLR(x_k) = \log \frac{\displaystyle\sum_{(i,l)\in B(k,1)} \alpha_{k-1}(S_{l,k-1}) \gamma_k^1(S_{l,k-1}, S_{i,k}) \beta_k(S_{i,k})}{\displaystyle\sum_{(i,l)\in B(k,0)} \alpha_{k-1}(S_{l,k-1}) \gamma_k^0(S_{l,k-1}, S_{i,k}) \beta_k(S_{i,k})} \qquad (5)$$

où B(k,0) (respectivement B(k,1)) est l'ensemble des transitions possibles d'un état $S_{l,k-1}$ vers un état $S_{i,k}$ provoquées par une donnée d'entrée égale à "0" (respectivement "1").

Le calcul du rapport LLR nécessite le calcul de multiplications et de valeurs exponentielles. Ces opérations sont difficiles à mettre en oeuvre. Pour ce faire, on introduit la fonction suivante :

$$MAX^+(x,y) = \ln(e^x + e^y) = MAX(x,y) + \ln(1 + e^{-|x-y|}) \qquad (6)$$

où le terme $\ln(1+e^{-|x-y|})$ est une valeur de correction appelée valeur d'ajustement. La valeur d'ajustement peut être obtenue au moyen d'une mémoire par exemple une mémoire ROM dans laquelle sont mémorisées des valeurs de la fonction $\ln(1+e^{-|v|})$ sur un nombre de bits déterminés pour certaines valeurs $|v|$ codées sur un nombre de bits déterminés. Il vient :

$$\ln(\sum_{i=0}^{N} e^{x_i}) = \text{MAX}^+(\ln(\sum_{i=0}^{N-1} e^{x_i}), x_i) \tag{7}$$

$$= \text{MAX}^+(\text{MAX}^+(\ln(\sum_{i=0}^{N-2} e^{x_i}), x_{N-1}), x_N) = ... = \underset{i\in[1,N]}{\text{MAX}}^+(x_i)$$

On introduit ainsi les définitions suivantes :

$$\bar{\gamma}_k (S_{m,n}, S_{i,k}) = \log(\gamma_k(S_{m,n}, S_{i,k})) \tag{8}$$

$$\bar{\alpha}_k (S_{i,k}) = \log(S_{i,k}) \tag{9}$$

Le terme $\bar{\alpha}_k(S_{i,k})$ est appelé métrique amont d'état ("forward state metrics") pour l'éta $S_{i,k}$ ou métrique amont de chemin pour l'état $S_{i,k}$.

$$\bar{\beta}_k (S_{i,k}) = \log(\beta_k(S_{i,k})) \tag{10}$$

Le terme $\bar{\beta}_k(S_{i,k})$ est appelé métrique aval d'état ("backward state metrics") pour l'état $S_{i,k}$ ou métrique aval de chemin pour l'état $S_{i,k}$.

Il en résulte que :

$$\bar{\alpha}_k(S_{i,k}) = \underset{m,j}{\text{MAX}}^+(\bar{\alpha}_{k-1}(S_{m,k-1}) + \bar{\gamma}_k^j(S_{m,k-1}, S_{i,k})) \tag{11}$$

$$\bar{\beta}_{k-1}(S_{i,k-1}) = \underset{m,j}{\text{MAX}}^+(\bar{\beta}_k(S_{m,k}) + \bar{\gamma}_k^j(S_{i,k-1}, S_{m,k})) \tag{12}$$

L'expression du rapport LLR devient alors :

$$\text{LLR}(x_k) = \underset{(i,m)\in B(k,1)}{\text{MAX}}^+(\bar{\alpha}_{k-1}(S_{m,k-1}) + \bar{\gamma}_k^1(S_{m,k-1}, S_{i,k}) + \bar{\beta}_k(S_{i,k}))$$

$$- \underset{(i,m)\in B(k,0)}{\text{MAX}}^+(\bar{\alpha}_{k-1}(S_{m,k-1}) + \bar{\gamma}_k^0(S_{m,k-1}, S_{i,k}) + \bar{\beta}_k(S_{i,k})) \tag{13}$$

Les calculs des métriques amont $\bar{\alpha}_k(S_{i,k})$ et aval $\bar{\beta}_k(S_{i,k})$ d'état sont réalisés par des modules particuliers du décodeurs appelés modules ACSO ("ADD-COMPARE-SELECT-OFFSET"-"Additionner-Comparer-Sélectionner-Ajustement") qui mettent en oeuvre la fonction MAX$^+$.

Le calcul des valeurs de métriques d'état doit être réalisé au moins à la fréquence de réception des données. Plus la fréquence de réception des données est élevée, plus il est difficile de réaliser ces opérations de calcul en un cycle de données unique. Pour ce faire, il existe de nombreuses configurations de modules de type ACSO de façon à réduire la durée de l'opération réalisée par le module. Toutefois, on atteint facilement les fréquences de fonctionnement limites du décodeur. La durée de l'opération réalisée par le module ACSO est donc un facteur critique à prendre en compte lors de la conception d'un décodeur.

La présente invention vise à obtenir un dispositif de type ACSO rapide.

La présente invention vise également à obtenir un dispositif de type ACSO de conception particulièrement simple.

Pour atteindre ces objets, la présente invention prévoit un dispositif pour réaliser une fonction de type addition-comparaison-sélection dans un décodeur de codes de correction d'erreur, comprenant un premier additionneur pour additionner, pour une première branche, une valeur de métrique de branche, une valeur intermédiaire de métrique d'état précédent, et une valeur d'ajustement de métrique d'état précédent, formant ainsi une première valeur de métrique d'état actuel ; un deuxième additionneur pour additionner, pour une deuxième branche, une valeur de métrique de branche, une valeur intermédiaire de métrique d'état précédent, et une valeur d'ajustement de métrique d'état précédent, formant ainsi une deuxième valeur de métrique d'état actuel ; un comparateur, couplé aux premier et second additionneurs, pour sélectionner la valeur la plus élevée des première et deuxième valeurs de métriques d'état actuel ; un premier moyen de mémorisation pour mémoriser la valeur de métrique d'état actuel sélectionnée ; des moyens pour déterminer une valeur numérique d'ajustement de métrique d'état actuel comportant un seul bit, à partir des première et deuxième valeurs de métriques d'état actuel ; et un second moyen de mémorisation pour mémoriser la valeur d'ajustement de métrique d'état actuel.

Selon un mode de réalisation de l'invention, les moyens pour déterminer la valeur numérique d'ajustement de métrique d'état actuel comprennent des moyens, couplés aux premier et second additionneurs, pour déterminer la valeur absolue de la différence entre les première et deuxième valeurs de métriques d'état actuel ; et un opérateur logique, couplé aux moyens pour déterminer ladite valeur absolue, pour déterminer la valeur numérique d'ajustement de métrique d'état actuel, à partir de ladite valeur absolue.

Selon un mode de réalisation de l'invention, les moyens pour déterminer la valeur absolue comprennent un premier soustracteur, couplé aux premier et second additionneurs, pour déterminer une première différence entre la première valeur de métrique d'état actuel et la deuxième valeur de métrique d'état actuel ; un deuxième soustracteur, couplé aux premier et second additionneurs, pour déterminer une deuxième différence entre la deuxième valeur de métrique d'état actuel et la première valeur de métrique d'état actuel ; des moyens, couplés aux premier et deuxième soustracteurs, pour comparer les première et deuxième différences et sélectionner la différence de valeur la plus élevée.

Selon un mode de réalisation de l'invention, l'opérateur logique comprend un extracteur, couplé aux moyens pour déterminer la valeur absolue, pour extraire un nombre déterminé de bits parmi les bits de la valeur absolue ; un module de calcul pour fournir la valeur numérique d'ajustement de métrique d'état actuel d'un seul bit à partir des bits extraits.

Selon un mode de réalisation de l'invention, les moyens pour déterminer la valeur numérique d'ajustement de métrique d'état actuel comprennent un premier soustracteur, couplé aux premier et second additionneurs, pour déterminer une première différence entre la première valeur de métrique d'état actuel et la deuxième valeur de métrique d'état actuel ; un deuxième soustracteur, couplé aux premier et second additionneurs, pour déterminer une deuxième différence entre la deuxième valeur de métrique d'état actuel et la première valeur de métrique d'état actuel ; un premier extracteur, couplé au premier soustracteur, pour fournir une première donnée extraite comprenant un nombre déterminé de bits parmi les bits de la première différence ; un deuxième extracteur, couplé au deuxième soustracteur, pour fournir une deuxième donnée extraite comprenant un nombre déterminé de bits parmi les bits de la deuxième différence ; un premier module de calcul, couplé au premier extracteur, pour fournir une première donnée de sélection à un seul bit à partir de la valeur des bits composant la première donnée extraite ; un deuxième module de calcul, couplé au deuxième extracteur, pour fournir une deuxième donnée de sélection à un seul bit à partir de la valeur des bits composant la deuxième donnée extraite ; des moyens, couplés aux premier et second modules de calcul, pour comparer les première et deuxième données de sélection et sélectionner la donnée de sélection de valeur la plus faible comme valeur d'ajustement de métrique d'état actuel.

L'invention prévoit également un procédé de réalisation d'une fonction de type addition-comparaison-sélection pour un décodage de codes de correction d'erreur, comprenant les étapes consistant à additionner, pour une première branche, une valeur de métrique de branche, une valeur intermédiaire de métrique d'état précédent, et une valeur d'ajustement de métrique d'état précédent, formant ainsi une première valeur de métrique d'état actuel ; additionner, pour une deuxième branche, une valeur de métrique de branche, une valeur intermédiaire de métrique d'état précédent, et une valeur d'ajustement de métrique d'état précédent, formant ainsi une deuxième valeur de métrique d'état actuel ; sélectionner la valeur la plus élevée des première et deuxième valeurs de métriques d'état actuel ; mémoriser la valeur de métrique d'état actuel sélectionnée ; déterminer une valeur numérique d'ajustement de métrique d'état actuel comportant un seul bit, à partir des première et deuxième valeurs de métriques d'état actuel ; et mémoriser la valeur d'ajustement de métrique d'état actuel.

Selon un mode de réalisation de l'invention, l'étape de détermination de la valeur numérique d'ajustement de métrique d'état actuel comprend les étapes consistant à déterminer la valeur absolue de la différence entre les première et deuxième valeurs de métriques d'état actuel ; et déterminer une valeur numérique d'ajustement de métrique d'état actuel comportant un seul bit, à partir de ladite valeur absolue.

Selon un mode de réalisation de l'invention, l'étape de détermination de la valeur numérique d'ajustement de métrique d'état actuel comprend les étapes consistant à déterminer une première différence entre la première valeur de métrique d'état actuel et la deuxième valeur de métrique d'état actuel ; déterminer une deuxième différence entre la deuxième valeur de métrique d'état actuel et la première valeur de métrique d'état actuel ; fournir une première donnée extraite comprenant un nombre déterminé de bits parmi les bits de la première différence ; fournir une deuxième donnée extraite comprenant un nombre déterminé de bits parmi les bits de la deuxième différence ; fournir une première donnée de sélection d'un seul bit à partir de la valeur des bits composant la première donnée extraite ; fournir une deuxième donnée de sélection d'un seul bit à partir de la valeur des bits composant la deuxième donnée extraite ; et comparer les première et deuxième données de sélection et sélectionner la donnée de sélection de valeur la plus faible comme valeur d'ajustement de métrique d'état actuel.

Ces objets, caractéristiques et avantages, ainsi que d'autres de la présente invention seront exposés en détail dans la description suivante de modes de réalisation particuliers faite à titre non limitatif en relation avec les figures jointes parmi lesquelles :

la figure 1, précédemment décrite, représente un exemple de treillis utilisé par un algorithme de décodage ;
la figure 2 représente un premier mode de réalisation d'un module ACSO selon la présente invention ; et
la figure 3 représente un second mode de réalisation d'un module ACSO selon la présente invention.

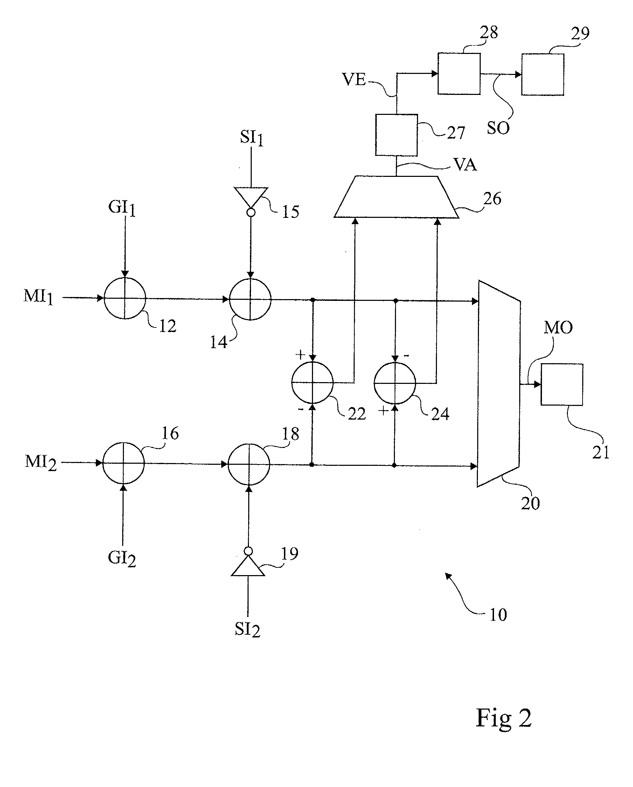

La figure 2 représente un module ACSO 10 permettant le calcul de la métrique d'état (amont ou aval) d'un état considéré à un instant donné k. Par la suite, on utilise le terme métrique d'état indifféremment pour une métrique d'état avant ou une métrique d'état arrière et, lorsqu'on fait référence à un état adjacent à l'état considéré, cela signifie un état à un instant ultérieur $k+1$ ou antérieur $k-1$ à l'état considéré, suivant la métrique considérée.

Le module ACSO 10 reçoit en entrée des premières données $MI_1$ et $MI_2$ qui représentent des valeurs intermédiaires de métriques d'état respectivement d'un premier état adjacent à l'état considéré, et d'un deuxième état adjacent à l'état considéré. Les données $MI_1$ et $MI_2$ sont codées sur un certain nombre de bits et sont lues dans une mémoire.

Le module ACSO 10 reçoit également en entrée des données $GI_1$ et $GI_2$ qui représentent des métriques de branche respectivement pour la branche entre le premier état adjacent et l'état considéré, et pour la branche entre le second état adjacent et l'état considéré.

Le module ACSO reçoit également en entrée des données $SI_1$ et $SI_2$ qui représentent des données d'ajustement associées respectivement à la métrique d'état du premier état adjacent et à la métrique d'état du deuxième état adjacent. $SI_1$ et $SI_2$ comprennent chacune un bit unique.

Le module 10 comprend un premier additionneur 12 qui réalise l'addition entre les données $MI_1$ et $GI_1$ et un second additionneur 14 qui réalise l'addition entre la somme issue de l'additionneur 12 et la donnée $SI_1$ inversée par un inverseur 15.

Le module 10 comprend un troisième additionneur 16 réalisant l'addition entre la donnée $MI_2$ et la donnée $GI_2$, et un quatrième additionneur 18 réalisant l'addition entre la somme issue de l'additionneur 16 et la donnée $SI_2$ inversée par un inverseur 19.

La somme des données $MI_1$, $GI_1$ et $SI_1$ correspond à une première valeur de métrique d'état de l'état considéré pour un chemin passant par le premier état adjacent. La somme des données $MI_2$, $GI_2$ et $SI_2$ correspond à une deuxième valeur de métrique d'état de l'état considéré pour un chemin passant par le deuxième état adjacent.

Un sélecteur 20 reçoit en entrée les première et deuxième métriques d'état et sélectionne entre les deux métriques d'état de l'état considéré la métrique d'état de valeur la plus élevée. La métrique d'état sélectionnée est conservée dans une mémoire 21, par exemple une série de bascules en parallèle.

Les première et deuxième valeurs de métriques d'état de l'état considéré alimentent un premier soustracteur 22 qui fournit une première différence entre la première valeur de métrique d'état et la deuxième valeur de métrique d'état. Les première et deuxième métriques d'état alimentent un deuxième soustracteur 24 qui fournit une deuxième différence entre la deuxième valeur de métrique d'état et la première valeur de métrique d'état. Les première et deuxième différences ont donc la même valeur absolue et sont de signe opposé.

Un sélectionneur 26 reçoit en entrée les différences issues des soustracteurs 22 et 24. Il sélectionne, parmi les deux différences, la différence de valeur la plus élevée appelée VA, c'est-à-dire la différence de signe positif, qui est donc égale à la valeur absolue de la différence entre les première et deuxième valeurs de métriques d'état de l'état considéré. La valeur absolue VA entre les première et deuxième valeurs de métriques d'état est donc avantageusement déterminée de façon simple au moyen de deux soustracteurs 22, 24 et d'un sélectionneur 26.

La valeur absolue VA est transmise à un extracteur 27 qui fournit une donnée VE correspondant à un nombre déterminé des bits les plus significatifs de la donnée VA. Un module de calcul 28 reçoit la donnée VE et fournit une donnée SO à un bit qui est égal à "1" si au moins un bit de la donnée de bits significatifs est égal à "1", et qui est égal à "0" dans le cas contraire. La donnée SO est mémorisée dans une mémoire 29 par exemple une bascule.

Au cours des itérations successives réalisées pour le décodage des données reçues par le décodeur, les données MO et SO fournies par le module ACSO 10 lors d'une itération sont utilisées par l'un des modules ACSO 10 du décodeur respectivement en tant que données d'entrée $MI_1$ ou $MI_2$ et $SI_1$ ou $SI_2$ lors de l'itération suivante.

A chaque module ACSO est associé un additionneur supplémentaire (non représenté) réalisant l'addition de la donnée MO et de l'inverse de SO. La donnée obtenue correspond à la métrique d'état de l'état actuel et est mémorisée lorsque l'algorithme de calcul a convergé.

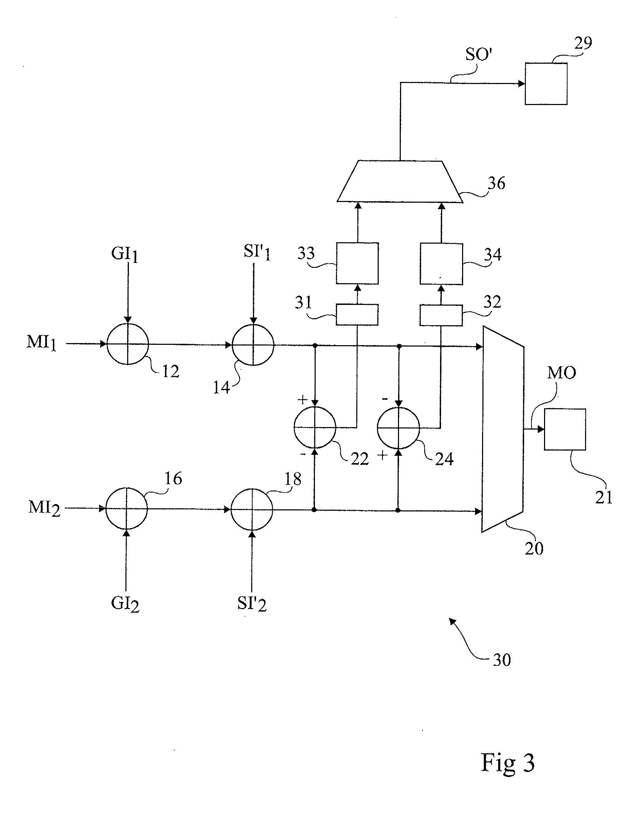

La figure 3 représente un second mode de réalisation du module 30 ACSO. Les éléments de la figure 3 remplissant les mêmes fonctions que les éléments de la figure 2 sont représentés avec les mêmes références, leur fonctionnement n'étant pas expliqué à nouveau par la suite. En figure 3, le deuxième additionneur 14 reçoit en entrée la somme du premier additionneur 12 qu'elle ajoute à une donnée $SI_1'$. Le quatrième additionneur 18 reçoit en entrée la somme du troisième additionneur 16 qu'il ajoute à une donnée $SI_2'$. Les données SI1' et SI2' représentent des données d'ajustement associées respectivement à la métrique d'état du premier état adjacent et à la métrique d'état du deuxième état adjacent. $SI_1'$ et $SI_2'$ comprennent chacune un bit unique.

La sortie de chaque soustracteur 22, 24 alimente un module extracteur 31, 32 qui fournit une donnée correspondant à un nombre déterminé des bits les plus significatifs de la donnée du soustracteur 22, 24. Un module de calcul 33 reçoit en entrée la donnée émise par l'extracteur 31 et fournit une donnée à un bit qui est égal à "0" si au moins un bit de la donnée reçue par le module 33 est égal à "1", et qui est égal à "1" dans le cas contraire. Un module de calcul 34 reçoit en entrée la donnée émise par l'extracteur 32 et fournit une donnée à un bit qui est égal à "0" si au moins un bit de la donnée reçue par le module 34 est égal à "1", et qui est égal à "1" dans le cas contraire.

Un sélectionneur 36 reçoit en entrée les données à un bit fournies par les modules de calcul 33, 34 et sélectionne la donnée de valeur la plus élevée, appelée SO', qui est mémorisée dans la mémoire 29.

La donnée SO' fournie par le module ACSO 30 lors d'une itération est utilisée par l'un des modules ACSO 30 du décodeur respectivement en tant que donnée d'entrée $SI_1'$ ou $SI_2'$ lors de l'itération suivante.

La demanderesse a mis en évidence que lors du fonctionnement d'un module ACSO classique, l'opération de durée la plus pénalisante est la détermination de la valeur d'ajustement, qui est réalisée par une mémoire ROM à laquelle on attribue en entrée une donnée |v| comportant un nombre de bits déterminé, et qui donne en sortie une donnée $Ln(1+e^{-|v|})$ sur un nombre de bits déterminé, ou par une opération synthétisée. La demanderesse a mis en évidence que l'utilisation d'une valeur d'ajustement à un seul bit n'entraîne pas de dégradation notable des performances du décodeur. En effet, le décodeur comporte d'autres systèmes tels qu'un convertisseur analogique-numérique dont le fonctionnement est davantage pénalisant pour les performances du décodeur de sorte que l'utilisation d'une valeur d'ajustement à un bit unique n'a qu'une faible influence sur les performances globales du décodeur.

Le module ACSO selon la présente invention ne comporte pas de mémoire à grande capacité, par exemple une mémoire ROM, à la différence d'un module ACSO classique, et n'est réalisé qu'avec des opérateurs logiques simples. Le module présente donc une architecture particulièrement simple qui permet de réduire la durée de fonctionnement d'une itération du module ACSO.

Le gain en temps obtenu par la présente invention autorise en outre l'ajout d'opérateurs logiques supplémentaires dans le module ACSO pour la mise en oeuvre de tests réalisés le plus souvent avant la vente du décodeur.

Bien entendu, la présente invention est susceptible de diverses variantes et modifications qui apparaîtront à l'homme de l'art. En particulier, chacun des composants décrits pourra être remplacé par un ou plusieurs composants remplissant la même fonction. Ainsi, les premier et deuxième (troisième et quatrième) additionneurs peuvent être remplacés par un additionneur à trois entrées.

**Revendications**

**1.** Dispositif (10, 30) pour réaliser une fonction de type addition-comparaison-sélection dans un décodeur de codes de correction d'erreur, comprenant :

-    un premier additionneur (12, 14) pour additionner, pour une première branche, une valeur de métrique de branche ($GI_1$), une valeur intermédiaire de métrique d'état précédent ($MI_1$), et une valeur d'ajustement de métrique d'état précédent ($SI_1$, $SI_1'$), formant ainsi une première valeur de métrique d'état actuel ;
-    un deuxième additionneur (16, 18) pour additionner, pour une deuxième branche, une valeur de métrique de branche ($GI_2$), une valeur intermédiaire de métrique d'état précédent ($MI_2$), et une valeur d'ajustement de métrique d'état précédent ($SI_2$, $SI_2'$), formant ainsi une deuxième valeur de métrique d'état actuel ;
-    un comparateur (20), couplé aux premier (12, 14) et second (16, 18) additionneurs, pour sélectionner la valeur la plus élevée (MO) des première et deuxième valeurs de métriques d'état actuel ;
-    un premier moyen de mémorisation (21) pour mémoriser la valeur de métrique d'état actuel sélectionnée (MO) ;

- des moyens (22, 24, 26, 27, 28, 31, 32, 33, 34, 36) pour déterminer une valeur numérique d'ajustement de métrique d'état actuel (SO, SO') comportant un seul bit, à partir des première et deuxième valeurs de métriques d'état actuel ; et
- un second moyen de mémorisation (29) pour mémoriser la valeur d'ajustement de métrique d'état actuel (SO, SO')

2. Dispositif selon la revendication 1, dans lequel les moyens (22, 24, 26, 27, 28) pour déterminer la valeur numérique d'ajustement de métrique d'état actuel (SO) comprennent :

- des moyens (22, 24, 26), couplés aux premier et second additionneurs, pour déterminer la valeur absolue (VA) de la différence entre les première et deuxième valeurs de métriques d'état actuel ; et
- un opérateur logique (28), couplé aux moyens pour déterminer ladite valeur absolue, pour déterminer la valeur numérique d'ajustement de métrique d'état actuel (SO), à partir de ladite valeur absolue (VA).

3. Dispositif selon la revendication 2, dans lequel les moyens (22, 24, 26) pour déterminer la valeur absolue (VA) comprennent :

- un premier soustracteur (22), couplé aux premier (12, 14) et second (16, 18) additionneurs, pour déterminer une première différence entre la première valeur de métrique d'état actuel et la deuxième valeur de métrique d'état actuel ;
- un deuxième soustracteur (24), couplé aux premier (12, 14) et second (16, 18) additionneurs, pour déterminer une deuxième différence entre la deuxième valeur de métrique d'état actuel et la première valeur de métrique d'état actuel ;
- des moyens (26), couplés aux premier (22) et deuxième (24) soustracteurs, pour comparer les première et deuxième différences et sélectionner la différence de valeur la plus élevée.

4. Dispositif selon la revendication 2, dans lequel l'opérateur logique (28) comprend :

- un extracteur (27), couplé aux moyens (22, 24, 26) pour déterminer la valeur absolue (VA), pour extraire un nombre déterminé de bits parmi les bits de la valeur absolue (VA) ;
- un module de calcul (28) pour fournir la valeur numérique d'ajustement de métrique d'état actuel (SO) d'un seul bit à partir des bits extraits.

5. Dispositif selon la revendication 1, dans lequel les moyens (22, 24, 31, 32, 33, 34, 36) pour déterminer la valeur numérique d'ajustement de métrique d'état actuel (SO') comprennent :

- un premier soustracteur (22), couplé aux premier (12, 14) et second (16, 18) additionneurs, pour déterminer une première différence entre la première valeur de métrique d'état actuel et la deuxième valeur de métrique d'état actuel ;
- un deuxième soustracteur (24), couplé aux premier (12, 14) et second (16, 18) additionneurs, pour déterminer une deuxième différence entre la deuxième valeur de métrique d'état actuel et la première valeur de métrique d'état actuel ;
- un premier extracteur (31), couplé au premier soustracteur (22), pour fournir une première donnée extraite comprenant un nombre déterminé de bits parmi les bits de la première différence ;
- un deuxième extracteur (32), couplé au deuxième soustracteur (24), pour fournir une deuxième donnée extraite comprenant un nombre déterminé de bits parmi les bits de la deuxième différence ;
- un premier module de calcul (33), couplé au premier extracteur (31), pour fournir une première donnée de sélection à un seul bit à partir de la valeur des bits composant la première donnée extraite ;
- un deuxième module de calcul (34), couplé au deuxième extracteur (32), pour fournir une deuxième donnée de sélection à un seul bit à partir de la valeur des bits composant la deuxième donnée extraite ;
- des moyens (36), couplés aux premier (33) et second (34) modules de calcul, pour comparer les première et deuxième données de sélection et sélectionner la donnée de sélection de valeur la plus faible comme valeur d'ajustement de métrique d'état actuel (SO').

6. Procédé de réalisation d'une fonction de type addition-comparaison-sélection pour un décodage de codes de correction d'erreur, comprenant les étapes suivantes :

- additionner, pour une première branche, une valeur de métrique de branche ($GI_1$), une valeur intermédiaire

de métrique d'état précédent ($MI_1$), et une valeur d'ajustement de métrique d'état précédent ($SI_1$), formant ainsi une première valeur de métrique d'état actuel ;

- additionner, pour une deuxième branche, une valeur de métrique de branche ($GI_2$), une valeur intermédiaire de métrique d'état précédent ($MI_2$), et une valeur d'ajustement de métrique d'état précédent ($SI_2$), formant ainsi une deuxième valeur de métrique d'état actuel ;
- sélectionner la valeur la plus élevée (MO) des première et deuxième valeurs de métriques d'état actuel ;
- mémoriser la valeur de métrique d'état actuel sélectionnée (MO) ;
- déterminer une valeur numérique d'ajustement de métrique d'état actuel (SO, SO') comportant un seul bit, à partir des première et deuxième valeurs de métriques d'état actuel ; et
- mémoriser la valeur d'ajustement de métrique d'état actuel (SO, SO').

7. Procédé selon la revendication 6, dans lequel l'étape de détermination de la valeur numérique d'ajustement de métrique d'état actuel (SO) comprend les étapes suivantes :

- déterminer la valeur absolue (VA) de la différence entre les première et deuxième valeurs de métriques d'état actuel ; et
- déterminer une valeur numérique d'ajustement de métrique d'état actuel (SO) comportant un seul bit, à partir de ladite valeur absolue (VA).

8. Procédé selon la revendication 6, dans lequel l'étape de détermination de la valeur numérique d'ajustement de métrique d'état actuel (SO') comprend les étapes suivantes :

- déterminer une première différence entre la première valeur de métrique d'état actuel et la deuxième valeur de métrique d'état actuel ;
- déterminer une deuxième différence entre la deuxième valeur de métrique d'état actuel et la première valeur de métrique d'état actuel ;
- fournir une première donnée extraite comprenant un nombre déterminé de bits parmi les bits de la première différence ;
- fournir une deuxième donnée extraite comprenant un nombre déterminé de bits parmi les bits de la deuxième différence ;
- fournir une première donnée de sélection d'un seul bit à partir de la valeur des bits composant la première donnée extraite ;
- fournir une deuxième donnée de sélection d'un seul bit à partir de la valeur des bits composant la deuxième donnée extraite ; et
- comparer les première et deuxième données de sélection et sélectionner la donnée de sélection de valeur la plus faible comme valeur d'ajustement de métrique d'état actuel (SO').

Fig 1

Fig 2

Fig 3

**Office européen des brevets**

# RAPPORT DE RECHERCHE EUROPEENNE

Numéro de la demande

EP 03 35 4009

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | EP 1 111 607 A (THOMSON BRANDT GMBH) 27 juin 2001 (2001-06-27) * page 5, alinéa 34 - page 6, alinéa 45; figure 3 * --- | 1-8 | H03M13/41 |
| A | US 2001/007142 A1 (DEFOSSEUX RAPHAEL ET AL) 5 juillet 2001 (2001-07-05) * page 12, alinéa 146 - page 13, alinéa 153; figure 10 * --- | 1-8 | |
| A | US 6 301 314 B1 (MURAYAMA JUN) 9 octobre 2001 (2001-10-09) * colonne 11, ligne 14 - colonne 12, ligne 13; figure 13 * ----- | 1-8 | |

DOMAINES TECHNIQUES RECHERCHES (Int.Cl.7)

H03M

Le présent rapport a été établi pour toutes les revendications

| Lieu de la recherche | Date d'achèvement de la recherche | Examinateur |
|---|---|---|
| LA HAYE | 12 mai 2003 | Devergranne, C |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
........................................................................
& : membre de la même famille, document correspondant

EPO FORM 1503 03 82 (P04C02)

**ANNEXE AU RAPPORT DE RECHERCHE EUROPEENNE
RELATIF A LA DEMANDE DE BREVET EUROPEEN NO.**   EP 03 35 4009

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

12-05-2003

| Document brevet cité au rapport de recherche | | Date de publication | Membre(s) de la famille de brevet(s) | | Date de publication |
|---|---|---|---|---|---|
| EP 1111607 | A | 27-06-2001 | EP | 1111605 A1 | 27-06-2001 |
| | | | EP | 1111607 A1 | 27-06-2001 |
| | | | CN | 1301020 A | 27-06-2001 |
| | | | JP | 2001210025 A | 03-08-2001 |
| | | | PL | 344713 A1 | 02-07-2001 |
| | | | US | 2001034870 A1 | 25-10-2001 |
| US 2001007142 | A1 | 05-07-2001 | EP | 1024604 A2 | 02-08-2000 |
| US 6301314 | B1 | 09-10-2001 | WO | 9818209 A1 | 30-04-1998 |

EPO FORM P0460

Pour tout renseignement concernant cette annexe : voir Journal Officiel de l'Office européen des brevets, No.12/82